# EUROPÄISCHE PATENTSCHRIFT

(11) **EP 1 043 627 B1**
(45) Veröffentlichungstag und Bekanntmachung des Hinweises auf die Patenterteilung: **12.06.2002**
(21) Anmeldenummer: 00107067.1
(22) Anmeldetag: 04.04.2000
(51) Int. Cl.: G03F 7/105

(54) **Aufzeichnungsmaterial mit pigmentgefärbter strahlungsempfindlicher Schicht**
Recording material having a pigment-colored radiation-sensitive layer
Matériau d'enregistrement avec couche pigmentée sensible aux rayons

(30) Priorität: 08.04.1999 DE 19915717
(43) Veröffentlichungstag der Anmeldung: 11.10.2000
(73) Patentinhaber: AGFA-GEVAERT, 2640 Mortsel (BE)
(72) Erfinder: Konrad, Klaus Peter, Dr. Dipl.-Chem., 65457 Gensingen (DE); Elsässer, Andreas, Dr. Dipl.-Chem., 65510 Idstein (DE); Fischer, Frank, Chemilaborant, 55124 Mainz (DE); Davies, John Kynaston, Dr. Dipl.-Chem., Rawdon, Leeds LS19 6ED (GB)

(56) Entgegenhaltungen:
- EP-A- 0 738 931
- EP-A- 0 778 497
- DE-A- 3 417 645
- US-A- 4 631 245

## Beschreibung

Gegenstand der vorliegenden Anmeldung ist ein Aufzeichnungsmaterial mit einem Träger und einer negativ arbeitenden, strahlungsempfindlichen Schicht, die ein Diazoniumsalz, metallfreie, organische Farbpigmente und ein polymeres Bindemittel enthält.

Aufzeichnungsmaterialien dieser oder ähnlicher Art sind bereits bekannt. So ist in der EP-A 152 819 (= US-A 4,631,245) ein negativ arbeitendes Aufzeichnungsmaterial zur Herstellung von Offsetdruckplatten beschrieben, dessen lichtempfindliche Schichtein Diazoniumsalz-Polykondensationsprodukt, ein Carboxylgruppen enthaltendes polymeres Bindemittel sowie gegebenenfalls einen Farbstoff und/oder Farbpigmente enthält. Zum Anfärben der Schicht wird beispielsweise eine unter der Bezeichnung ®Renolblau B2G-HW von der Clariant Deutschland GmbH erhältliche Anteigung eines blauen Kupfer-Phthalocyanin-Pigments (®Hostapermblau B2G) in einem modifizierten Polyvinylbutyral (®Mowital B30H) verwendet. Die so vorbehandelten Pigmente lösen sich jedoch nur langsam und in begrenztem Umfang in der Beschichtungslösung, was den Pigmentanteil und damit den später erreichbaren Bildkontrast begrenzt. Durch eine Verlängerung der Rührzeit im Ansatzkessel läßt sich eine bessere Vermischung erreichen, jedoch kann bei größeren Lösungsansätzen eine unerwünschte Schlammbildung eintreten. Kupferhaltige Pigmente führen darüber hinaus zu einer ebenso unerwünschten Anreicherung von Kupfer in den wäßrigen Bädern, in denen die Aufzeichnungsmaterialien nach der bildmäßigen Bestrahlung entwickelt werden. Kupfer-Phthalocyanin-Pigmente wie auch Polyvinylbutyrale lösen sich zudem nur begrenzt in wäßrig-alkalischen Entwicklern, so daß sich bei hoher Entwicklerbelastung häufig Niederschläge aus Schichtbestandteilen bilden. Die Niederschläge wiederum können die Funktion der Entwicklungsmaschinen wie auch die der entwickelten Platten (durch die Bildung von Redeposits) beeinträchtigen.

Gegenstand der EP-A 778 497 ist ein negativ arbeitendes Aufzeichnungsmaterial, das sich insbesondere zur Herstellung von Offsetdruckplatten eignet.

Die nicht belichteten Bereiche der strahlungsempfindlichen Schicht des Aufzeichnungsmaterials lassen sich mit neutralen oder alkalischen wäßrigen Lösungen entfemen. Die Schicht enthält vordispergierte Pigmente, bevorzugt vordispergierte Kupfer-Phthalocyanin-Pigmente, eine Diazoniumverbindung oder eine Kombination aus einer photopolymerisierbaren Verbindung und einem Photoinitiator sowie ein in wäßrig-alkalischen Lösungen lösliches, zumindest aber quellbares polymeres Bindemittel. Das Bindemittel ist hergestellt durch Umsetzung eines Hydroxygruppen enthaltenden Polymers mit einem Anhydrid, z. B. Maleinsäure- oder Bemsteinsäureanhydrid, in Gegenwart einer katalytisch wirksamen Menge eines tertiären Amins. Als besonders geeignete Bindemittel sind anhydridmodifizierte Polyvinylacetale offenbart. Die Säurezahl des Bindemittels liegt allgemein bei 5 bis 80. Das Bindemittel dient auch zur Dispergierung der Farbpigmente. In der Pigmentdispersion beträgt der Anteil des Bindemittels 2 bis 20 Gew.-%. Daneben umfaßt die Pigmentdispersion 60 bis 96 Gew.-% eines aliphatischen (C₁-C₈)Alkohols, eines (C₁-C₈)Alkylenglykol-mono- oder -di-(C₁-C₈)alkylethers (insbesondere 1-Methoxy-propan-2-ol) oder eines cyclischen Ketons. Durch die Vordispergierung läßt sich der Anteil der Farbpigmente in der Schicht steigern, was den Bildkontrast in dem entwickelten Aufzeichnungsmaterial steigert und auf diese Weise das Bild besser sichtbar macht. Durch diese Maßnahme wird gleichzeitig erreicht, daß die Schicht in den nicht bestrahlten Bereichen vollständig entfernt wird und bereits abgelöste Schichtbestandteile sich nicht erneut ablagem, was beim späteren Drucken zu einem Hintergrundschleier oder zum Tonen führen würde. Die. Vordispergierung wird üblicherweise in einer Kugelmühle durchgeführt. Wird dabei ein organisches Lösemittel mit relativ niedrigem Siedepunkt eingesetzt (wie 1-Methoxy-propan-2-ol, das bei Normaldruck einen Siedepunkt von 118 bis 119 °C aufweist), so ist eine intensive Kühlung der Mühle unbedingt erforderlich.

Es wurde auch bereits versucht, die beschriebenen Mängel der im Stand der Technik bekannten Aufzeichnungsmaterialien zu beheben. So ist in der EP-A 738 931 die Anfärbung einer negativ arbeitenden Schicht mit schwermetallfreien, insbesondere kupferfreien, vordispergierten Phthalocyanin-Pigmenten offenbart. Die Vordispergierung erfolgt mit einem Polyvinylalkohol in Wasser in Gegenwart eines kationischen, oberflächenaktiven Mittels. Auf diese Weise lassen sich zwar stabile Dispersionen erzeugen, die aber nur in wäßrigen Medien einsetzbar sind. Die Pigment-Dispersion gemäß der EP-A wird dementsprechend in einer wäßrigen lichtempfindlichen Zusammensetzung verwendet, die neben einem wasserlöslichen Diazoharz oder Diazoniumsalz einen Polyvinylalkohol als Bindemittel enthält. Der hohe Gehalt an Polyvinylalkohol in den damit hergestellten Schichten führt häufig zu Problemen bei der Farbannahme beim Drucken. Auch sind solche Schichten nicht ausreichend resistent gegen das beim Drucken verwendete Feuchtmittel, so daß nur relativ geringe Druckauflagen erreicht werden können. In lichtempfindlichen Gemischen, die nicht wasserlösliche Diazo- oder Diazonium-Komponenten und/oder nicht wasserlösliche polymere Bindemittel enthalten, ist die Pigmentdispersion praktisch nicht einsetzbar.

Es bestand daher die Aufgabe, ein mit einer metallfreien Farbpigmentdispersion eingefärbtes, negativ arbeitendes Aufzeichnungsmaterial bereitzustellen, bei dem das aus der strahlungsempfindlichen Schicht durch bildmäßiges Bestrahlen und anschließendes Entwickeln geformte Bild intensiv eingefärbt ist und sich kontrastreich von dem Träger abhebt. Mit der Farbpigmentdispersion soll sich insbesondere eine negativ arbeitende lichtempfindliche Zusammensetzung auf nicht-wäßriger Basis homogen einfärben lassen. Als flüssige Phase der Dispersion sollen hochsiedende (Siedepunkt bei Normaldruck größer als 180 °C) Lösemittel verwendbar sein, damit bei Vermahlung der Pigmente größere Verluste an Lösemittel vermieden werden. Die Dispersion soll sich zudem in der nicht-wäßrigen lichtempfindlichen Zusammensetzung in kurzer Zeit gleichmäßig verteilen lassen, und zwar auch in größeren Mengen um eine intensive Anfärbung zu erreichen. Die Dispersion und die damit hergestellte Schicht sollen zudem frei von Tensiden und niedermolekularen Dispergatoren sein. Die druckenden Bereiche der aus dem Aufzeichnungsmaterial erhaltenen Offsetplatte sollen nach dem Entwickeln so klar erkennbar sein, daß die Platte, falls erforderlich, korrigiert werden kann. Die klare Erkennbarkeit ist femer wichtig, damit die Platte bei der Druckvorbereitung von einem Scanner einwandfrei abgetastet werden kann. Die Dispersion soll schließlich auch den Entwicklungsprozeß nicht beeinträchtigen. Auch wenn der Entwickler bereits stark mit Schichtbestandteilen aus dem Aufzeichnungsmaterial belastet ist, sollen die Farbpigmente nicht aus dem Entwicklergemisch ausfallen oder gar Ablagerungen in der Entwicklungsmaschine oder auf den entwickelten Platten bilden.

Schließlich bestand auch die Aufgabe, ein Aufzeichnungsmaterial mit einem verbesserten Abstandshaltersystem zu schaffen. Dadurch werden Filmvorlage und Platte beim Evakuieren rascher kontaktiert und der bei der Bestrahlung gebildete Stickstoff kann besser ausgasen, was sich beim späteren Drucken in einer gleichmäßigeren Rasterwiedergabe auswirkt. Bekannte Abstandshalterpigmente können bei Aufzeichnungsmaterialien der bisher beschriebenen Art nicht in einer Menge zugegeben werden, wie sie für eine optimale Oberflächenrauhigkeit wünschenswert ist, denn sie können bei der Fertigung zu Beschichtungsfehlstellen führen.

Gelöst wurde die Aufgabe durch die Verwendung von Farbpigmenten, die in einem polymeren, organischen Bindemittel vordispergiert und mit transparenten Pigmenten kombiniert sind, die ein bestimmtes Porenvolumen haben.

Gegenstand der vorliegenden Erfindung ist demgemäß ein Aufzeichnungsmaterial mit einem Träger und einer negativ arbeitenden, strahlungsempfindlichen Schicht, die ein Diazoniumsalz, metallfreie, organische Farbpigmente und ein polymeres Bindemittel enthält, das dadurch gekennzeichnet ist, daß die metallfreien organischen Farbpigmente mit einem organischen, polymeren Bindemittel dispergiert sind und daß die Schicht transparente Abstandshalterpigmente mit einem spezifizierten Porenvolumen von mehr als 1,0 ml/g enthält. Die Bestimmung der Porenvolumen erfolgt nach den bekannten Methoden der N₂-/H₂O- oder Hg-Adsorption (vgl. Anal. Chem. 28 (3), 332 (1956), J. Colloid Interface Sci. 78 (1980), 31 und Proc. Nat. Acad. Sci. 7 (1921), 115).

Die transparenten Abstandshalterpigmente haben bevorzugt ein Porenvolumen von mehr als 1,5 ml/g. Die Dispergierung der metallfreien organischen Farbpigmente erfolgt vorzugsweise indem diese vermahlen werden in einem organischen Lösemittel, das einen Siedepunkt bei Normaldruck von 180 °C oder mehr aufweist, mit einem organischen, polymeren Bindemittel, das Hydroxygruppen enthält, die zum Teil oder insgesamt mit einem intramolekularen Di- oder Polycarbonsäureanhydrid umgesetzt sind, so daß das Bindemittel eine Säurezahl von 20 bis 200 aufweist.

Zusätzlich enthält die strahlungsempfindliche Schicht gegebenenfalls noch eine Kombination aus einem polymerisierbaren Monomer oder Oligomer und einem Photopolymerisationsinitiator.

Die metallfreien organischen Farbpigmente sind bevorzugt Phthalocyanin-Pigmente, insbesondere das Phthalocyanin selbst (= ®Heliogenblau D7490; Color Index No. 74 100; Pigment Blue 16). Der Anteil der dispergierten Pigmente beträgt allgemein 2 bis 20 Gew.-%, bevorzugt 4 bis 12 Gew.-%, jeweils bezogen auf das Gesamtgewicht der Dispersion.

Als Bindemittel sind vor allem Polymere mit Vinylalkohol-Einheiten geeignet. Polyvinylalkohole und Polyvinylacetale, die noch freie Hydroxygruppen aufweisen, sind besonders bevorzugt. Geeignet sind jedoch auch andere hydroxygruppenhaltige Polymere, wie Epoxyharze oder Homo- oder Copolymere mit Hydroxyalkyl-(meth)acryiat-Einheiten. Um die Bindemittel für die Zwecke der vorliegenden Erfindung brauchbar zu machen, werden sie durch Umsetzung mit einem intramolekularen Di- oder Polycarbonsäureanhydrid alkalilöslich gemacht. Prinzipiell geeignet sind sowohl aliphatische oder cycloaliphatische wie auch aromatische oder heteroaromatische intramolekulare Di- oder Polycarbonsäureanhydride. Von den (cyclo)aliphatischen Di- oder Polycarbonsäureanhydriden sind Maleinsäureanhydrid, Dimethylmaleinsäureanhydrid, Citraconsäureanhydrid, Bemsteinsäureanhydrid, Glutarsäureanhydrid, Cyclohexen-1,2-dicarbonsäureanhydrid oder Camphersäureanhydrid zu nennen. Besonders bevorzugte aromatische Anhydride sind Phthalsäureanhydrid oder Trlmellitsäureanhydrid. Geeignet sind aber auch Naphthalin-2,3-dicarbonsäureanhydrid oder -1,8-dicarbonsäureanhydrid und heteroaromatische Säureanhydride wie Furan-oder Thiophen-2,5-dicarbonsäureanhydrid. Umsetzungsprodukte mit aromatischen Carbonsäureanhydriden führen zu Druckplatten mit einer besseren Haltbarkeit, so daß eine höhere Druckauflage erreicht werden kann. Aromatische und heteroaromatische Carbonsäureanhydride sind aus diesem Grunde gegenüber den aliphatischen oder cydoaliphatischen bevorzugt. Durch die Umsetzung mit dem Carbonsäureanhydrid hat das zum Dispergieren eingesetzten polymere Bindemittel allgemein eine Säurezahl von 20 bis 200, bevorzugt von 50 bis 150, besonders bevorzugt 55 bis 120; sein mittleres Molekulargewicht M_{W} liegt allgemein bei 10.000 bis 300.000, bevorzugt bei 20.000 bis 200.000. Als besonders günstig hat es sich erwiesen, die Umsetzung des Hydroxygruppen enthaltenden polymeren Bindemittels mit den aromatischen Di- oder Polycarbonsäureanhydriden in Gegenwart einer organischen oder anorganischen Base, wie Triethylamin oder Natriumcarbonat, auszuführen. Der Anteil des zum Dispergieren verwendeten polymeren Bindemittels beträgt allgemein 2 bis 30 Gew.-%, bevorzugt 5 bis 20 Gew.-%, bezogen auf das Gesamtgewicht der Dispersion.

Die Vordispergierung der Farbpigmente wird allgemein in polaren organischen Lösemitteln durchgeführt. Beispiele dafür sind Ethylenglykol-monomethylether, Diethylenglykol-monomethylether, N-Methyl-pyrrolidon, Ethylenglykol-monobutylether-acetat oder γ-Butyrolacton. Es können auch Gemische verschiedener Lösemittel verwendet werden. Der Siedepunkt der Lösemittel bei Normaldruck beträgt vorzugsweise 180 °C oder mehr, insbesondere 180 bis 280 °C. Dadurch wird der Verlust an Lösemittel während des Vermahlens vermindert, und es kann auf eine spezielle Kühlung verzichtet werden. Die erfindungsgemäße Pigmentdispersion enthält praktisch kein Wasser. Daher müssen die organischen Lösemittel auch nicht wassermischbar sein. Der Anteil des hochsiedenden polaren organischen Lösemittels beträgt allgemein 50 bis 96 Gew.-%, bezogen auf das Gesamtgewicht der Farbpigmentdispersion.

Von der Farbpigmentdispersion wird so viel dem negativ arbeitenden Gemisch hinzugefügt, daß der Anteil an reinen Farbpigmenten etwa 2 bis 20 Gew.-%, bevorzugt 3 bis 15 Gew.-%, beträgt, jeweils bezogen auf das Gesamtgewicht der nichtflüchtigen Bestandteile der daraus hergestellten negativ arbeitenden strahlungsempfindlichen Schicht.

Ein besonderer Vorzug des erfindungsgemäßen Aufzeichnungsmaterials besteht darin, daß es ohne den Zusatz von oberflächenaktiven Mitteln auskommt. Solche Mittel sind nachteilig, denn sie beeinträchtigen allgemein die Resistenz der Schicht beim Drucken.

Herstellen läßt sich die Farbpigmentdispersion mit üblichen und dem Fachmann bekannten Vorrichtungen, insbesondere mit einer Kugelmühle. Es hat sich als günstig erwiesen, zunächst die zum Dispergieren vorgesehenen Bindemittel in dem organischen Lösemittel zu lösen, dann die metallfreien Pigmente zuzusetzen und das Gemisch anschließend in einer Kugelmühle unter Zusatz von Glas- oder Keramikperlen (Durchmesser der Mahlperlen etwa 1 mm) zu vermahlen. Optimale Ergebnisse werden erreicht, wenn der Mahlgang mehrmals wiederholt wird. Bei der Prüfung unter dem Durchlichtmikroskop sollen keine Teilchen mit einem Durchmesser von mehr als 3 µm sichtbar sein. Die Stabilität der Farbpigmentdispersion ist ausreichend, wenn das damit eingefärbte strahlungsempfindliche Gemisch 3 Tage lang bei Raumtemperatur gelagert werden kann, ohne daß sich während dieser Zeit feste Bestandteile absetzen.

Neben den vordispergierten Farbpigmenten enthält das strahlungsempfindliche Gemisch transparente Pigmente, insbesondere Pigmente auf der Basis von SiO₂ oder Al₂O₃ oder Mischungen davon. Die transparenten Pigmente haben allgemein einen mittleren Durchmesser von 1 bis 10 µm und Porenvolumina von mehr als 1,0 ml/g, bevorzugt 1,5 bis 2,5 ml/g. Sie dienen in erster Linie als Abstandshalter bei der Kontaktbebilderung und verhindern die Bildung von Lufteinschlüssen zwischen Filmvorlage und strahlungsempfindlichem Aufzeichnungsmaterial. Unter "transparenten" Pigmenten sollen hier solche verstanden werden, die für sichtbares Licht transparent sind. Auch diese Pigmente können vordispergiert sein, vorzugsweise mit denselben Bindemitteln und Lösemitteln wie die Farbpigmente. Der Anteil der transparenten Pigmente beträgt allgemein 0,1 bis 10,0 Gew.-%, bevorzugt 0,5 bis 5,0 Gew.-%, jeweils bezogen auf das Gesamtgewicht der nichtflüchtigen Bestandteile der strahlungsempfindlichen Schicht.

Die strahlungsempfindliche Komponente in der negativ arbeitenden strahlungsempfindlichen Schicht ist ein Diazoniumsalz oder eine Kombination aus einem Diazoniumsalz mit einem polymerisierbaren Monomer oder Oligomer und einem Photopolymerisationsinitiator. Als polymere Bindemittel können die in solchen Gemischen allgemein üblichen verwendet werden. In einer besonders bevorzugten Ausführungsform ist das Bindemittel im strahlungsempfindlichen Gemisch jedoch identisch mit dem zum Dispergieren der genannten Pigmente verwendeten.

Das lichtempfindliche Diazoniumsalz ist vorzugsweise ein Kondensationsprodukt eines aromatischen Diazoniumsalzes. Derartige Kondensationsprodukte sind u.a. aus der DE-A 1214 086 (= US-A 3 235 384) bekannt. Sie werden im allgemeinen durch Kondensation einer mehrkemigen aromatischen Diazoniumverbindung, vorzugsweise von substituierten oder unsubstituierten Diphenylamin-4-diazoniumsalzen mit aktiven Carbonylverbindungen, vorzugsweise Formaldehyd, in stark saurem Medium, vorzugsweise konzentrierter Phosphorsäure, hergestellt.

In den US-A 3 867 147 und 4 021 243 sind Kondensationsprodukte beschrieben, die zusätzlich durch Kondensation entstandene Einheiten enthalten, die von Diazoniumsalzgruppen frei sind und vorzugsweise von aromatischen Aminen, Phenolen, Phenolethem, aromatischen Thioethem, aromatischen Kohlenwasserstoffen, aromatischen heterocyclischen Verbindungen oder organischen Säureamiden abgeleitet sind.

Das Diazoniumsalz-Polykondensationsprodukt enthält somit bevorzugt wiederkehrende Einheiten R-N₂X, die durch Zwischenglieder miteinander verbunden sind, die von kondensationsfähigen Carbonylverbindungen, insbesondere Formaldehyd, abgeleitet sind, wobei R ein mindestens zwei Benzolringe enthaltender aromatischer Rest und X ein Anion ist. Das Diazoniumsalz-Polykondensationsprodukt kann auch aus wiederkehrenden Einheiten A-N₂X und B bestehen, die durch Zwischenglieder, vorzugsweise Methylengruppen miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist. Außerdem kann es ein Produkt mit wiederkehrenden Einheiten A-N₂X und B sein, die durch zweibindige, von einer kondensationsfähigen Carbonylverbindung abgeleitete Zwischenglieder verbunden sind. Die Diazoniumsalzeinheiten A-N₂X leiten sich bevorzugt von Verbindungen der Formel

(R¹-R²-)ₚR³-N₂X

ab, wobei
- X: ein Anion,
- p: eine ganze Zahl von 1 bis 3,
- R¹: einen aromatischen Rest mit mindestens einer zur Kondensation mit aktiver Carbonylverbindung befähigten Position,
- R²: eine Einfachbindung oder eine der Gruppen:

-(CH₂)_{q}-NR⁴-,

-O-(CH₂)ᵣ-NR⁴-,

-S-(CH₂)ᵣ-NR⁴-,

-S-CH₂-CO-NR⁴-,

-O-R⁵-O-,

-O-,

- S-

oder

-CO-NR⁴-

worin
q eine Zahl von 0 bis 5,
r eine Zahl von 2 bis 5,
R⁴ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen und
R⁵ eine Arylengruppe mit 6 bis 12 C-Atomen ist, und
- R³: einen ggf. substituierten (p+1)-wertigen Benzolrest
bedeuten.

Der (p+1)-wertige Benzolrest ist bevorzugt mit (C₁-C₄)Alkoxy- oder (C₁-C₆)Alkylgruppen substituiert. p ist bevorzugt 1, was bedeutet, daß R³ bevorzugt eine gegebenenfalls substituierte Phenylengruppe ist.

Das Anion X ist vorzugsweise das Chlorid, Sulfat, Phosphat, oder ein gegebenenfalls substituiertes Alkansulfonat mit 1 bis 4 Kohlenstoffatomen, z.B. das Methansulfonat oder ein Aminoalkansulfonat, wie es in der EP-A 224 162 beschrieben ist. Wenn das (C₁-C₄)Alkansulfonat substituiert ist, dann bevorzugt mit Amino- oder Alkoxygruppen.

Bevorzugt werden Kondensationsprodukte, die sich von gegebenenfalls substituierten Diphenylamin-4-diazoniumsalzen, insbesondere von 3-Methoxy-diphenylamin-4-diazoniumsalzen, ableiten und von diesen die leicht zugänglichen Kondensationsprodukte mit Formaldehyd. Die gegebenenfalls vorhandenen Substituenten sind bevorzugt (C₁-C₄)Alkoxy- oder (C₁-C₆)Alkylgruppen. Die Kondensation kann vor allem in konzentrierter Schwefel-, Phosphor- oder Methansulfonsäure, insbesondere in Phosphorsäure durchgeführt werden. Im letzteren Fall kann das Kondensationsprodukt als Rohkondensat eingesetzt werden, d.h. die bei der Kondensation anfallende etwa 50%ige Lösung in Phosphorsäure kann direkt verwendet werden. Das hat den Vorteil, daß die zur Stabilisierung des Kondensationsprodukts im Gemisch bevorzugte Phosphorsäure bereits vorhanden ist. Zur Stabilisierung sind auch Schwefelsäure, Methansulfonsäure, *para*-Toluolsulfonsäure oder Citronensäure geeignet. Ein Überschuß an Säure ist häufig vorteilhaft, so daß auch zusätzlich zu der im Rohkondensat enthaltenen noch mehr Phosphorsäure zugesetzt werden kann.

Das nur gegebenenfalls vorhandene polymerisierbare Monomer oder Oligomer ist allgemein eine ethylenisch ungesättigte Verbindung, bevorzugt ein Ester oder Amid der Acryl-, Methacryl-, Fumar- oder Maleinsäure. Von diesen sind wiederum die Verbindungen mit mehr als einer polymerisierbaren Doppelbindung bevorzugt. Dazu gehören beispielsweise die Ester der genannten Säuren mit Alkandiolen, Poly- oder Oligoethylenglykolen, Poly- oder Oligopropylenglykolen, Poly- oder Oligobutylenglykolen und anderen bifunktionellen nieder- oder hochmolekularen organischen Diolen. Besonders geeignet sind die Ester von mehrwertigen Alkoholen, wie Glycerin, Trimethylolethan bzw. -propan, Pentaerythrit, Isocyanursäure, deren ethoxylierten oder propoxylierten Derivaten, sowie Dimere oder Oligomere dieser Verbindungen. Ein möglichst hoher Veresterungsgrad ist dabei vorteilhaft. Ebenfalls verwendbar sind Amide, beispielsweise die Verbindungen, die formal bei der Umsetzung von Ethylendiamin oder dessen Oligomeren mit den beschriebenen Säuren entstehen. Der Anteil der polymerisierbaren Monomere und/oder Oligomere beträgt etwa 5 bis 80 Gew.-%, bevorzugt etwa 10 bis 60 Gew.-%, jeweils bezogen auf das Gesamtgewicht der nichtflüchtigen Bestandteile der strahlungsempfindlichen Schicht.

Als Photopolymerisationsinitiatoren, die unter Einwirkung von aktinischer Strahlung, insbesondere sichtbarem oder UV-Licht, die Polymerisation des polymerisierbaren Monomers oder Oligomers einleiten, kommen je nach gewünschtem Sensibilisierungsbereich unterschiedliche Materialien zum Einsatz. Soll das lichtempfindliche Material für den im Offsetdruck üblichen nahen UV-Bereich (350 bis 420 nm) empfindlich sein, so werden andere Photoinitiator-Systeme verwendet, als wenn im sichtbaren Spektralbereich, beispielsweise mit Laserstrahlung, belichtet werden soll.

Die im nahen UV-Bereich zu belichtenden Photoinitiatoren sollen Licht im Bereich zwischen ca. 250 und 500 nm unter Ausbildung von Radikalen absorbieren. Beispiele sind Acyloine und deren Derivate, wie Benzoin, Benzoinalkylether, vicinale Diketone und deren Derivate, z. B. Benzil, Benzilacetale wie Benzildimethylketal, Fluorenone, Thioxanthone, Mehrkemchinone, Acridine und Chinoxaline, femer Trichlormethyl-s-triazine, 2-Halogenmethyl-4-vinyl-[1,3,4]oxadiazol-Derivate, mit Trichlormethylgruppen substituierte Halogenoxazole, Trihalogenmethylgruppen enthaltende Carbonylmethylenheterocyclen und Acylphosphinoxid-Verbindungen. Die Photoinitiatoren lassen sich auch in Kombination miteinander oder mit Coinitiatoren bzw. Aktivatoren verwenden, z. B. mit Michlers Keton oder einem Derivat davon oder mit einem 2-Alkyl-anthrachinon. Bei den besonders für Bestrahlung im sichtbaren Bereich eingesetzten Photoinitiatoren kommen meist Gemische aus Metallocenen, photoreduzierbaren Farbstoffen, photolytisch spaltbaren Verbindungen mit Trihalogenmethylgruppen und gegebenenfalls weiteren Initiator- und Farbstoffbestandteilen in Frage, wie sie in der EP-A 364 735 beschrieben sind. Die Metallocen-Komponente besteht aus verschiedenartig substituierten Cyclopentadienyl-Komplexen des Titans oder Zirkoniums. Als photoreduzierbare Farbstoffe können Xanthen-, Benzoxanthen-, Benzothioxanthen-, Thiazin-, Pyronin-, Porphyrin- oder Acridin-Farbstoffe verwendet werden. Bei den Trihalogenmethyl-Coinitiatoren haben sich besonders die bekannten TriazinDerivate mit Brom oder Chlor als Halogen bewährt. Außerdem enthält der Initiator zur Steigerung der Empfindlichkeit im nahen W-Bereich z. B. Acridin-, Phenazinoder Chinoxalin-Derivate und im sichtbaren Bereich z. B. Dibenzalacetone oder Cumarine.

Die Menge des Photoinitiators bzw. der Initiatorkombination beträgt im allgemeinen etwa 0,1 bis 15 Gew.-%, bevorzugt etwa 0,5 bis 10 Gew.-%, jeweils bezogen auf das Gesamtgewicht der nichtflüchtigen Bestandteile der strahlungsempfindlichen Schicht.

Die photopolymerisierbare Schicht kann darüber hinaus Stabilisatoren zur Unterdrückung von thermischer Polymerisation, Weichmacher oder andere Hilfsstoffe zur Verbesserung der mechanischen oder reprographischen Qualität enthalten. Dabei ist grundsätzlich zu beachten, daß die beigefügten Stoffe keinen übergroßen Anteil des für die Polymerisation notwendigen aktinischen Lichtes absorbieren und dadurch die praktische Lichtempfindlichkeit herabsetzen.

Um das Gemisch fließfähig zu machen, so daß es auf ein Trägermaterial aufgetragen werden kann, wird zweckmäßig noch ein organisches Lösemittel hinzugefügt. Allgemein sind beispielsweise Alkohole, Ketone, Ester oder Ether geeignet. Besonders günstig sind (Partial-)Ether oder Ether-Ester von Alkylenglykolen (insbesondere Ethylenglykol und Propylenglykol), Dialkylenglykolen oder Polyalkylenglykolen. Zu nennen sind beispielsweise Diethylenglykol-mono(C₁-C₆)-alkylether, speziell Diethylenglykol-monomethylether, -monoethyl oder -monobutylether. Um einen guten Schichtverlauf und eine gleichmäßige Schichtoberfläche zu erreichen, umfaßt das Beschichtungslösemittel vorzugsweise niedrigsiedende (Siedepunkt bei Normaldruck kleiner als 150 °C, vorzugsweise 50 bis 120 °C; Beispiele: Tetrahydrofuran, Ethylenglykol-monomethylether) wie auch hochsiedende (Siedepunkt bei Normaldruck größer als 180 °C; Beispiele: Diethylenglykol-mono(C₁-C₆)alkylether) organische Lösemittel. Die hochsiedenden sind dabei zweckmäßig identisch mit denen, die bei der Dispergierung der Farbpigmente eingesetzt werden.

Als Träger eignen sich Platten, Folien oder Bänder aus Metall, aus Kunststoff oder aus Kunststoff/Metall-Laminaten. Bevorzugt sind jedoch metallische Träger, insbesondere solche aus Aluminium oder einer Aluminiumlegierung. Die Aluminiumträgerwerden üblicherweise mechanisch, chemisch und/oderelektrochemisch aufgerauht, bei Bedarf auch anodisch oxidiert und/oder mit einer hydrophilierend wirkenden Beschichtung (z.B. einer Beschichtung aus Polyvinylphosphonsäure) versehen. Das strahlungsempfindliche Gemisch kann durch Aufschleudem, Aufgießen oder nach anderen allgemein üblichen und bekannten Verfahren auf den Träger aufgebracht werden. Anschließend wird die Beschichtung getrocknet, beispielsweise in einem Umluftofen. Das Gewicht der getrockneten strahlungsempfindlichen Schicht beträgt allgemein 0,3 bis 3,0 g/m², bevorzugt 0,5 bis 2,0 g/m², besonders bevorzugt 0,6 bis 1,6 g/m².

Das strahlungsempfindliche Aufzeichnungsmaterial wird dann bildmäßig bestrahlt. Je nach Art der lichtempfindlichen Komponente kann UV-, sichtbare oder IR-Strahlung verwendet werden. Allgemein wird durch eine Filmvorlage hindurch bestrahlt. Die Vorlage wird dazu in einem Vakuum-Kontaktkopierrahmen auf die direkt auf die strahlungsempfindliche Schicht gelegt. Vor dem Bestrahlen wird die zwischen der Filmvorlage und dem Aufzeichnungsmaterial verbliebene Luft dann abgepumpt.

Nach der bildmäßigen Bestrahlung wird das Aufzeichnungsmaterial dann mit einer für Negativ-Aufzeichnungsmaterialien passenden wäßrig-alkalischen Lösung entwickelt. Solche Lösungen sind bekannt und beispielsweise in der DE-A 197 55 295 beschrieben. Ein besonders geeigneter Entwickler enthält mindestens eine in Wasser alkalisch reagierende Verbindung, mindestens einen Emulgator, mindestens ein mit Wasser mischbares organisches Lösemittel und mindestens ein Tensid. Die alkalisch reagierende Verbindung ist vorzugsweise ein Alkanolamin (insbesondere Ethanolamin, Di- oder Triethanolamin, Isopropanolamin, Diisopropanolamin oder Tris-hydroxymethyl-aminomethan), ein Hydroxid (insbesondere Alkali- oder Erdalkalihydroxide), ein Phosphat oder ein Carbonat (insbesondere Natrium-, Kalium- oder Ammoniumcarbonate oder -hydrogencarbonate). Der Anteil der alkalisch reagierenden Verbindung liegt allgemein bei 0,1 bis 20 Gew.-%, insbesondere 0,5 bis 10 Gew.-%, jeweils bezogen auf das Gesamtgewicht des gebrauchsfertigen Entwicklers. Dessen pH-Wert liegt allgemein bei 8 bis 13, bevorzugt 8,5 bis 11,5.

Der Emulgator ist allgemein ein Copolymer mit Einheiten aus hydrophoben Vinylverbindungen und hydrophilen, ethylenisch ungesättigten Carbonsäuren, wobei ein Teil der Carboxygruppen des Copolymers auch noch verestert ist. Der Anteil der Emulgatoren beträgt allgemein 0,1 bis 10 Gew.-%, bevorzugt 0,2 bis 8,0 Gew.-%.

Als "mischbar mit Wasser" werden in diesem Zusammenhang solche organischen Lösemittel bezeichnet, die in der verwendeten Menge (bis zu etwa 20 Gew.-%) bei einer Temperatur, bei der Entwickler normalerweise gelagert oder verwendet werden (etwa 0 bis 60 °C), mit Wasser eine einheitliche Lösung bilden. Besonders geeignete organische Lösemittel sind Alkohole, wie Benzylalkohol, Ethylenglykol-monophenylether, 1-oder2-Phenyl-ethanol, Glycerin oder Glycerinacetate. Der Anteil dieser Lösemittel beträgt allgemein 0,5 bis 15,0 Gew.-%, bevorzugt 1,0 bis 10,0 Gew.-%, besonders bevorzugt 2,0 bis 6,0 Gew.-%, jeweils bezogen auf das Gesamtgewicht des gebrauchsfertigen Entwicklers.

Von den Tensiden eignen sich besonders die anionischen Tenside. Daneben können auch Gemische von anionischen mit nicht-ionischen oder zwitterionischen Tensiden mit Erfolg eingesetzt werden. Bewährt haben sich vor allem anionische Tenside wie Alkalimetall-octylsulfate, -dodecylbenzolsulfonate, -alkylphenolethersulfate, -naphthalinsulfonate, -sulfosuccinate, und -alkyletherphosphate. Nichtionische Tenside stammen beispielsweise aus den Substanzklassen der (C₁₀-C₁₈)Fettalkoholethoxylate, der Polyethylenglykole, Ethylenoxid/Propylenoxid-(Block-)Copolymerisate und Alkylphenolethoxylate. Der Anteil der Tenside beträgt allgemein 0,2 bis 12,0 Gew.-%, bevorzugt 0,5 bis 8,0 Gew.-%, besonders bevorzugt 1,0 bis 6,0 Gew.-%, bezogen auf das Gesamtgewicht des Entwicklers.

Nach der Entwicklung heben sich die Bereiche, die später die Druckfarbe annehmen, deutlich sichtbar und kontrastreich von dem Trägermaterial ab. Der reflexionsdensitometrisch unter Verwendung eines Cyanfilters bestimmte Unterschied in der optischen Dichte zwischen dem (freigelegten) Träger und den Schichtbereichen beträgt in der Regel mindestens 0,8. Durch die Farbpigmentierung wird weder der Entwicklungsprozeß beeinträchtigt noch die Druckauflage herabgesetzt. Aufgrund des hohen Kontrasts kann die so erhaltene Druckplatte, falls erforderlich, besonders leicht korrigiert werden. Noch bedeutsamer ist, daß der Anteil der druckenden Bereiche der Platte durch einen Scanner besonders zuverlässig erfaßt werden kann. Aus dem erfindungsgemäßen Aufzeichnungsmaterial lassen sich Druckplatten herstellen, die ohne weiteres Auflagen von 250.000 bis 300.000 Drucken erreichen können.

Die folgenden Ausführungsbeispiele sollen die Erfindung eriäutem. "Gt" steht darin für Gewichtsteil(e). Prozente sind Gewichtsprozente, soweit nicht anders angegeben. Vergleichsbeispiele und Vergleichssubstanzen sind durch ein Sternchen (*) gekennzeichnet.

### Beispiele:

Das in den Beispielen verwendete Diazoniumsalz war jeweils ein Diazoniumsalz-Polykondensationsprodukt, hergestellt aus äquimolaren Mengen 3-Methoxydiphenylamin-4-diazoniumsulfat und 4,4'-Bis-methoxymethyl-diphenylether in 85%iger Phosphorsäure, isoliert als Mesitylensulfonat.

Daneben wurden die folgenden polymeren Bindemittel bzw. Dispergatoren verwendet:
- P1:: ein Polyvinylbutyral mit einem mittleren Molekulargewicht M_{W} von etwa 37.000, das 71 mol-% and Vinylbutyral-, 27 mol-% Vinylalkohol- und 2 mol-% Vinylacetat-Einheiten enthielt und in einem Gemisch aus Y-Butyrolacton und Butanon (Mischungsverhältnis 1 Gt: 2 Gt) in Gegenwart von Triethylamin umgesetzt war mit Benzol-1,2,4-tricarbonsäureanhydrid (= Trimellitsäureanhydrid); das in Wasser ausgefällte Umsetzungsprodukt hatte eine Säurezahl von etwa 100 mg KOH/g
- P2:: ein Polyvinylbutyral mit einem mittleren Molekulargewicht M_{W} von etwa 80.000, das 71 mol-% and Vinylbutyral-, 27 mol-% Vinylalkohol- und 2 mol-% Vinylacetat-Einheiten enthielt und in Diethylenglykol-monomethylether ("Methyldiglykol") in Gegenwart von wasserfreiem Natrium-carbonat umgesetzt war mit Phthalsäureanhydrid; das in Wasser ausgefällte Umsetzungsprodukt hatte eine Säurezahl von etwa 70 mg KOH/g
- P3:: ein Polyvinylbutyral mit einem mittleren Molekulargewicht M_{W} von etwa 80.000, das 71 mol-% and Vinylbutyral-, 27 mol-% Vinylalkohol- und 2 mol-% Vinylacetat-Einheiten enthielt und in Butanon in Gegenwart von Triethylamin umgesetzt war mit Maleinsäureanhydrid; das in Wasser ausgefällte Umsetzungsprodukt hatte eine Säurezahl von etwa 40 mg KOH/g

Mit diesen polymeren Bindemitteln wurden auf die bereits beschriebene Weise in einer Rührwerkskugelmühle zunächst die in der Tabelle 1 aufgeführten Farbpigmentdispersionen hergestellt (MEK steht dabei für Methyl-ethyl-keton = Butanon, THF für Tetrahydrofuran).

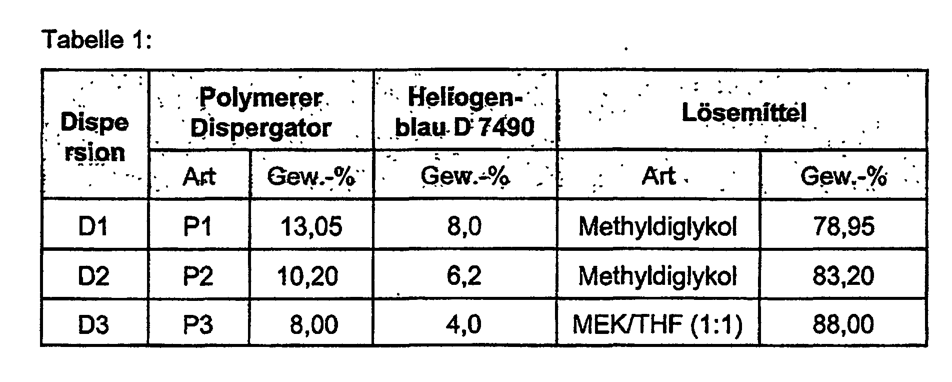

Mit den so erhaltenen Farbpigmentdispersionen wurden dann die in Tabelle 2 aufgeführten Beschichtungsgemische hergestellt. Die Gemische wurde jeweils mindestens eine Stunde lang intensiv gerührt.

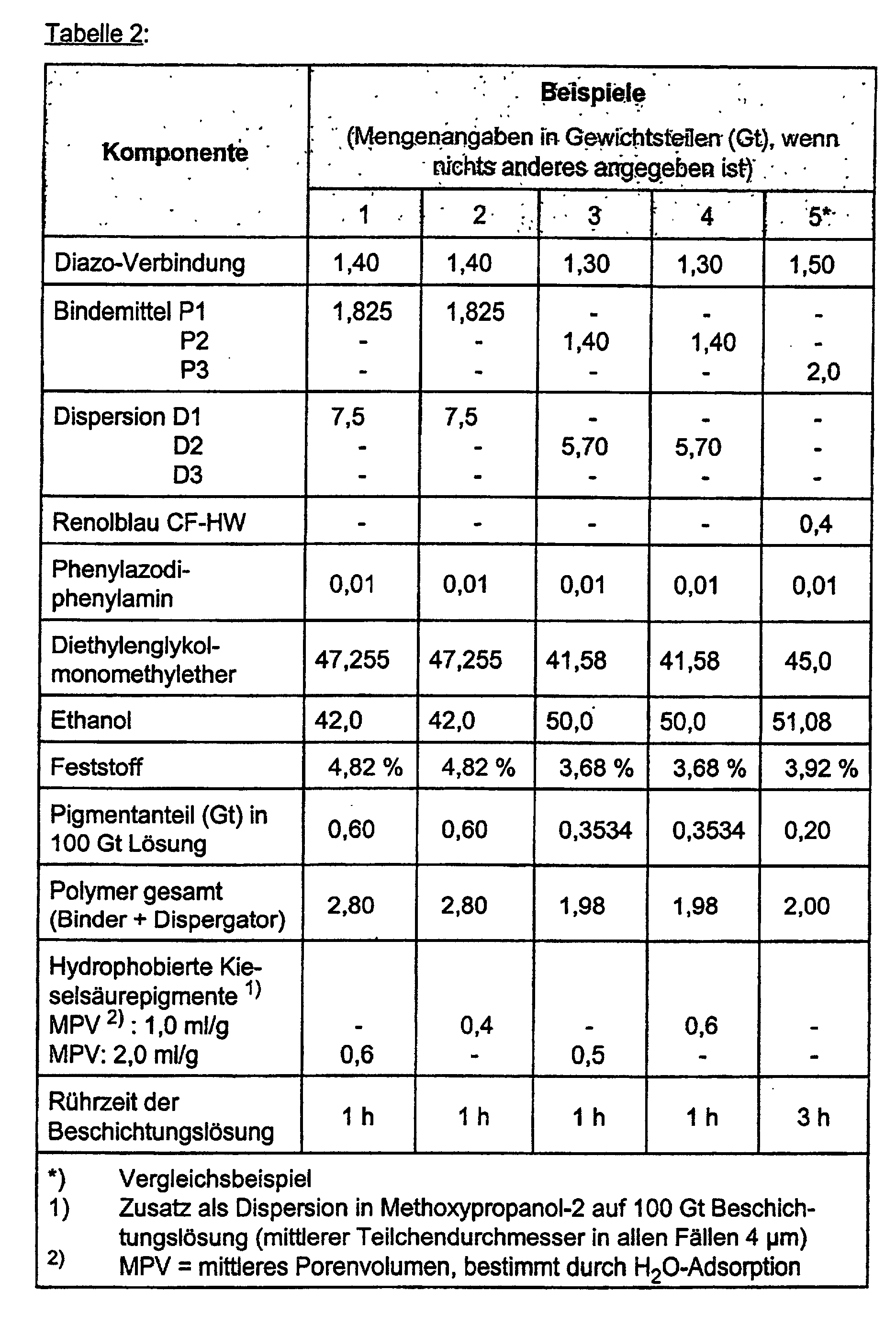

Die in Tabelle 2 genannten negativ arbeitenden Gemische wurden dann jeweils auf eine 300 µm dicke Aluminiumfolie aufgeschleudert, wobei die Folie vorher in verdünnter Salpetersäure aufgerauht (R_{z} -Wert gemäß DIN 4768: 6,0 µm), in verdünnter Schwefelsäure zwischengebeizt, anodisiert (Oxidgewicht 2,0 g/m²) und mit Polyvinylphosphonsäure hydrophiliert worden war. Nach dem Trocknen hatte die negativ arbeitende Schicht ein Gewicht von 1,0 g/m².

Die auf diese Weise hergestellten Aufzeichnungsmaterialien wurden dann unter einer Filmvorlage in einem Vakuum-Kontaktkopierrahmen mit UV-Licht bildmäßig bestrahlt (Bestrahlungsenergie etwa 400 mJ/cm²). Anschließend wurden sie mit einem handelsüblichen wäßrig-alkalischen Entwickler für Negativ-Druckplatten (Agfa EN 232) entwickelt. Die folgende Tabelle 3 zeigt die Charakteristika der einzelnen Platten:

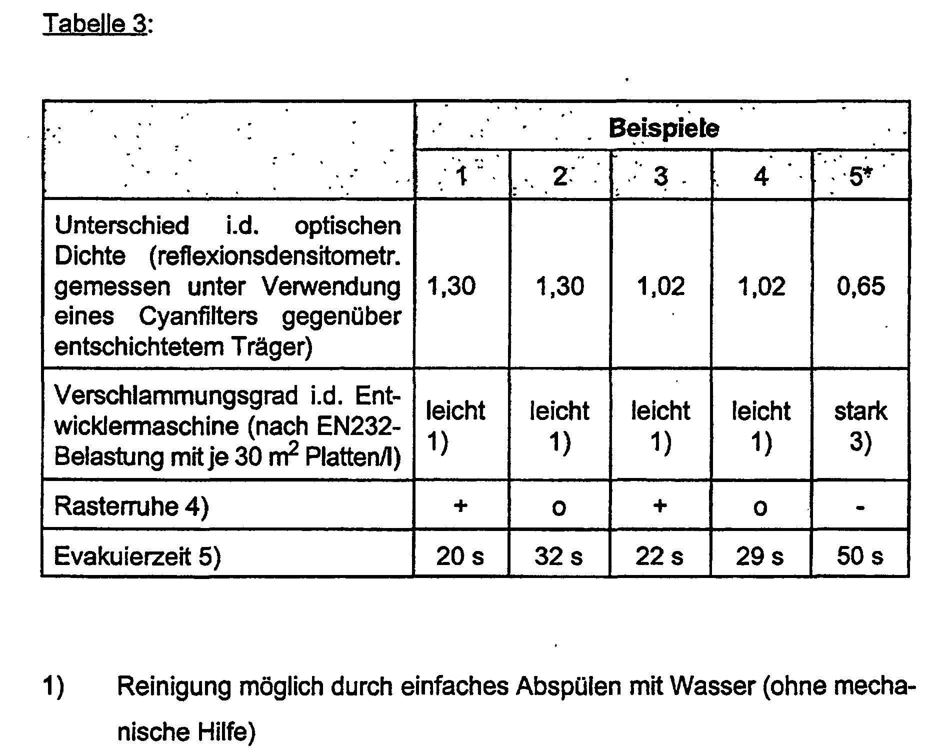

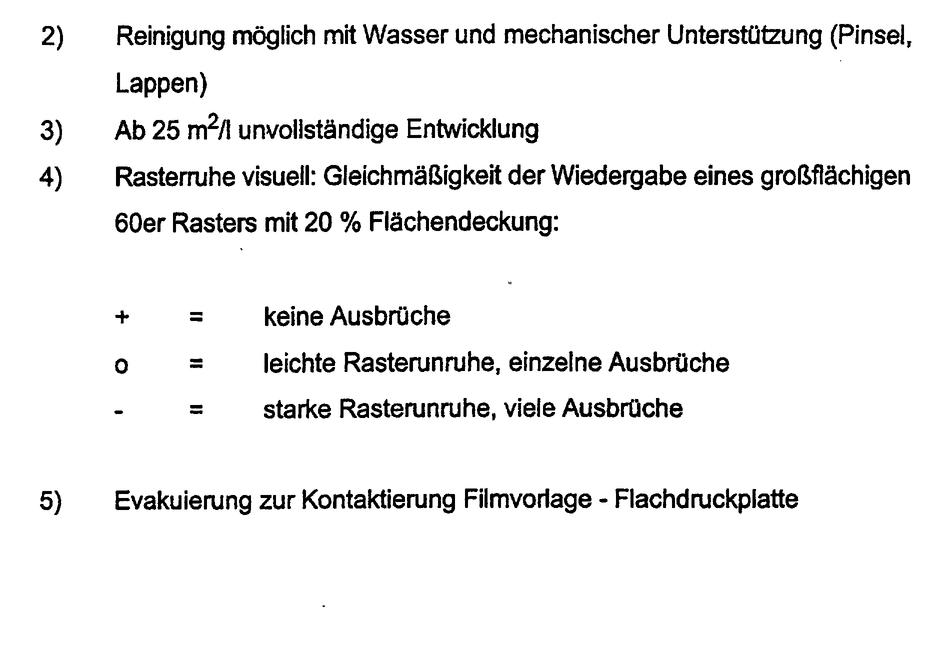

## Patentansprüche

1. Aufzeichnungsmaterial mit einem Träger und einer negativ arbeitenden, strahlungsempfindlichen Schicht, die ein Diazoniumsalz, metallfreie organische Farbpigmente und ein polymeres Bindemittel enthält, **dadurch gekennzeichnet, daß** die metallfreien organischen Farbpigmente in einem organischen, polymeren Bindemittel dispergiert sind und daß die Schicht transparente Abstandshalterpigmente mit einem Porenvolumen von mehr als 1,0 ml/g enthält.

2. Aufzeichnungsmaterial gemäß Anspruch 1, **dadurch gekennzeichnet, daß** die transparenten Abstandshalterpigmente ein Porenvolumen von mehr als 1,5 ml/g aufweisen.

3. Aufzeichnungsmaterial gemäß Anspruch 1 oder 2, **dadurch gekennzeichnet, daß** das organischen, polymere Bindemittel Hydroxygruppen enthält, die zum Teil oder insgesamt mit einem intramolekularen Di- oder Polycarbonsäureanhydrid umgesetzt sind, so daß das Bindemittel eine Säurezahl von 20 bis 200 aufweist.

4. Aufzeichnungsmaterial gemäß Anspruch 1 oder 2, **dadurch gekennzeichnet, daß** die strahlungsempfindliche Schicht zusätzlich eine Kombination aus einem polymerisierbaren Monomer oder Oligomer und einem Photopolymerisationsinitiator enthält.

5. Aufzeichnungsmaterial gemäß Anspruch 3, **dadurch gekennzeichnet, daß** das Hydroxygruppen enthaltende polymere Bindemittel ein Polymer mit Vinylalkohol-Einheiten ist, bevorzugt ein Polyvinylalkohol oder Polyvinylacetal, das noch freie Hydroxygruppen aufweist.

6. Aufzeichnungsmaterial gemäß einem oder mehreren der Ansprüche 3 bis 5, **dadurch gekennzeichnet, daß** das Di- oder Polycarbonsäureanhydrid ein aliphatisches, cycloaliphatisches, aromatisches oder heteroaromatisches intramolekulares Di- oder Polycarbonsäureanhydrid ist.

7. Aufzeichnungsmaterial gemäß Anspruch 6, **dadurch gekennzeichnet, daß** das aromatische intramolekulare Di- oder Polycarbonsäureanhydrid Phthalsäure- oder Trimellitsäureanhydrid ist.

8. Aufzeichnungsmaterial gemäß einem oder mehreren der Ansprüche 1 bis 7, **dadurch gekennzeichnet, daß** das polymere Bindemittel eine Säurezahl von 50 bis 150 aufweist.

9. Aufzeichnungsmatedal gemäß einem oder mehreren der Ansprüche 1 bis 8, **dadurch gekennzeichnet, daß** das polymere Bindemittel ein mittleres Molekulargewicht M_{W} von 10.000 bis 300.000, bevorzugt 20.000 bis 200.000, aufweist.

10. Aufzeichnungsmaterial gemäß einem oder mehreren der Ansprüche 3 bis 9, **dadurch gekennzeichnet, daß** die Umsetzung der Hydroxygruppen des polymeren Bindemittels mit den aromatischen Di- oder Polycarbonsäureanhydriden in Gegenwart einer organischen oder anorganischen Base, bevorzugt Triethylamin oder Natriumcarbonat, ausgeführt wird.

11. Aufzeichnungsmaterial gemäß einem oder mehreren der Ansprüche 1 bis 10, **dadurch gekennzeichnet, daß** das Vermahlen der Farbpigmente zusammen mit einem organischen Lösemittel oder Lösemittelgemisch erfolgt, dessen Siedepunkt bei Normaldruck 180 °C oder mehr, bevorzugt 180 bis 280 °C, beträgt.

12. Aufzeichnungsmaterial gemäß einem oder mehreren der Ansprüche 1 bis 11, **dadurch gekennzeichnet, daß** die transparenten Pigmente auf SiO₂ oder Al₂O₃ oder Mischungen davon basieren.

13. Aufzeichnungsmaterial gemäß einem oder mehreren der Ansprüche 1 bis 12, **dadurch gekennzeichnet, daß** die transparenten Pigmente einen mittleren Durchmesser von 1 bis 10 µm, bevorzugt 2 bis 6 µm, aufweisen.

14. Aufzeichnungsmaterial gemäß einem oder mehreren der Ansprüche 1 bis 13, **dadurch gekennzeichnet, daß** der Träger ein metallischer Träger ist, bevorzugt ein Träger aus Aluminium oder einer Aluminiumlegierung.

15. Aufzeichnungsmaterial gemäß Anspruch 14, **dadurch gekennzeichnet, daß** der Aluminiumträger mechanisch, chemisch und/oder elektrochemisch aufgerauht, gegebenenfalls auch anodisch oxidiert und/oder mit einer hydrophilierend wirkenden Beschichtung versehen ist.

## Claims

1. A recording material comprising a substrate and a negative-working photosensitive layer containing a diazonium salt, metal-free organic coloured pigments and a polymeric binder, **characterised in that** the metal-free organic coloured pigments are dispersed in an organic polymeric binder, and **in that** said layer contains transparent spacer pigments having a pore volume greater than 1.0 ml/g.

2. The recording material according to claim 1, **characterised in that** said transparent spacer pigments have a pore volume greater than 1.5 ml/g.

3. The recording material according to claim 1 or 2, **characterised in that** said organic, polymeric binder contains hydroxyl groups, which have been reacted in part or in whole with an intramolecular di- or polycarboxylic anhydride so that the binder has an acid number in the range of 20 to 200.

4. The recording material according to claim 1 or 2, **characterised in that** said photosensitive layer further contains a combination of a polymerisable monomer or oligomer and a photopolymerisation initiator.

5. The recording material according to claim 3, **characterised in that** said polymeric binder containing hydroxyl groups is a polymer having vinyl alcohol units, preferably a poly(vinyl alcohol) or a poly(vinyl acetal) having free hydroxyl groups.

6. The recording material according to any of claims 3 to 5, **characterised in that** said di- or polycarboxylic anhydride is an aliphatic, cycloaliphatic, aromatic or heteroaromatic intramolecular di- or polycarboxylic anhydride.

7. The recording material according to claim 6, **characterised in that** said aromatic intramolecular di- or polycarboxylic anhydride is phthalic or trimellitic anhydride.

8. The recording material according to any of claims 1 to 7, **characterised in that** said polymeric binder has an acid number in the range of 50 to 150.

9. The recording material according to any of claims 1 to 8, **characterised in that** said polymeric binder has an average molecular weight M_{W} in the range of 10 000 to 300 000, preferably in the range of 20 000 to 200 000.

10. The recording material according to any of claims 3 to 9, **characterised in that** the reaction of the hydroxyl groups of the polymeric binder with the aromatic di- or polycarboxylic anhydrides is carried out in the presence of an organic or inorganic base, preferably triethylamine or sodium carbonate.

11. The recording material according to any of claims 1 to 10, **characterised in that** said coloured pigments are ground together with an organic solvent or solvent mixture the boiling point of which at atmospheric pressure is at least 180°C, preferably in the range of 180°C to 280°C.

12. The recording material according to any of claims 1 to 11, **characterised in that** said transparent pigments are based upon SiO₂, Al₂O₃ or mixtures thereof.

13. The recording material according to any of claims 1 to 12, **characterised in that** said transparent pigments have an average diameter in the range of 1 to 10 µm, preferably in the range of 2 to 6 µm.

14. The recording material according to any of claims 1 to 13, **characterised in that** said substrate is a metallic substrate, preferably a substrate made of aluminium or an aluminium alloy.

15. The recording material according to claim 14, **characterised in that** said aluminium substrate is mechanically, chemically and/or electrochemically grained, optionally additionally anodised and/or provided with a hydrophilising coating.

## Revendications

1. Matériau d'enregistrement comprenant un support et une couche photosensible à effet négatif contenant un sel de diazonium, des pigments colorés organiques exempts de métaux et un liant polymère, **caractérisé en ce que** lesdits pigments colorés organiques exempts de métaux sont dispersés dans un liant polymère organique, et **en ce que** ladite couche contient des pigments d'espacement transparents possédant un volume poreux supérieur à 1.0 ml/g.

2. Matériau d'enregistrement selon la revendication 1, **caractérisé en ce que** lesdits pigments d'espacement transparents possèdent un volume poreux supérieur à 1,5 ml/g.

3. Matériau d'enregistrement selon la revendication 1 ou 2, **caractérisé en ce que** ledit liant polymère organique contient des groupes hydroxyle, qui ont réagi en partie ou en totalité avec un anhydride dicarboxylique ou polycarboxylique intramoléculaire de telle manière que le liant possède un indice d'acidité de 20 à 200.

4. Matériau d'enregistrement selon la revendication 1 ou 2, **caractérisé en ce que** ladite couche photosensible contient en outre une combinaison d'un monomère ou oligomère polymérisables et un agent d'amorçage de photopolymérisation.

5. Matériau d'enregistrement selon la revendication 3, **caractérisé en ce que** ledit liant polymère contenant des groupes hydroxyle est un polymère à unités d'alcool vinylique, de préférence un poly(alcool vinylique) ou un poly(acétal de vinyle) à groupes hydroxyle libres.

6. Matériau d'enregistrement selon l'une quelconque des revendications 3 à 5, **caractérisé en ce que** ledit anhydride dicarboxylique ou polycarboxylique est un anhydride dicarboxylique ou polycarboxylique intramoléculaire aliphatique, cycloaliphatique, aromatique ou hétéroaromatique.

7. Matériau d'enregistrement selon la revendication 6, **caractérisé en ce que** ledit anhydride dicarboxylique ou polycarboxylique intramoléculaire aromatique est l'anhydride phtalique ou trimellitique.

8. Matériau d'enregistrement selon l'une quelconque des revendications 1 à 7, **caractérisé en ce que** ledit liant polymère possède un indice d'acidité de 50 à 150.

9. Matériau d'enregistrement selon l'une quelconque des revendications 1 à 8, **caractérisé en ce que** ledit liant polymère possède un poids moléculaire moyen M_{W} compris entre 10 000 et 300 000, de préférence entre 20 000 et 200 000.

10. Matériau d'enregistrement selon l'une quelconque des revendications 3 à 9, **caractérisé en ce que** la réaction des groupes hydroxyle du liant polymère avec les anhydrides dicarboxylique ou polycarboxylique aromatiques est effectuée en présence d'une base organique ou inorganique, de préférence la triéthylamine ou le carbonate de sodium.

11. Matériau d'enregistrement selon l'une quelconque des revendications 1 à 10, **caractérisé en ce que** lesdits pigments colorés sont broyés conjointement avec un solvant organique ou mélange de tels solvants dont le point d'ébullition sous pression atmosphérique s'élève à au moins 180°C, de préférence il est compris entre 180°C et 280°C.

12. Matériau d'enregistrement selon l'une quelconque des revendications 1 à 11, **caractérisé en ce que** lesdits pigments transparents se basent sur SiO₂, Al₂O₃ ou leurs mélanges.

13. Matériau d'enregistrement selon l'une quelconque des revendications 1 à 12, **caractérisé en ce que** lesdits pigments transparents possèdent un diamètre moyen comrpis entre 1 et 10 µm, de préférence entre 2 à 6 µm.

14. Matériau d'enregistrement selon l'une quelconque des revendications 1 à 13, **caractérisé en ce que** ledit support est un support métallique, de préférence un support en aluminium ou un alliage d'aluminium.

15. Matériau d'enregistrement selon la revendication 14, **caractérisé en ce que** ledit support en aluminium est grené par voie mécanique, chimique et/ou électrochimique, éventuellement en outre anodisé et/ou enduit d'une couche hydrophilisante.
